Europäisches Patentamt

(19) European Patent Office

Office européen des brevets

(11) Numéro de publication: **0 017 083**

**A1**

(12) **DEMANDE DE BREVET EUROPEEN**

(21) Numéro de dépôt: **80101435.8**

(22) Date de dépôt: **19.03.80**

(51) Int. Cl.³: **H 01 L 35/30**
**H 01 L 35/32, H 01 L 25/08**
**F 25 B 21/02, F 25 B 29/00**

(30) Priorité: **26.03.79 FR 7907519**

(43) Date de publication de la demande:
**15.10.80 Bulletin 80/21**

(84) Etats Contractants Désignés:
**BE CH DE FR GB IT NL SE**

(71) Demandeur: **COMPAGNIE EUROPEENNE POUR L'EQUIPEMENT MENAGER "CEPEM" Société anonyme dite:**
**12, rue de la Baume**
**F-75008 Paris(FR)**

(72) Inventeur: **Berthet, Michel**
**2, Domaine de Miremont**
**F-91190 Gif Sur Yvette(FR)**

(72) Inventeur: **Kermarrec, Jean-Claude**
**73 bis rue Lavoisier**
**F-78140 Velizy-Villacoublay(FR)**

(72) Inventeur: **Ravelet, Robert**
**26 boulevard Diderot**
**F-91120 Palaiseau(FR)**

(74) Mandataire: **Weinmiller, Jürgen et al,**
**Zeppelinstrasse 63**
**D-8000 München 80(DE)**

(54) **Dispositif thermoélectrique à transfert de chaleur entre deux fluides.**

㉗ Ce dispositif constitue par exemple une pompe à chaleur eau-air comportant une pile (P1) formée d'une succession d'étages alimentés électriquement en série et comportant chacun deux thermoéléments (20 et 22) de types opposés séparés par des conducteurs thermiques (54, 16) incorporés dans des échangeurs de chaleur pour les deux fluides, la structure d'échangeur à eau (16) créant à chaque étage une élasticité longitudinale, tandis que l'empilement des échangeurs à air (54, 40, 42, 28) constitue une colonne de maintien assurant la tenue mécanique du dispositif et évitant toute tension mécanique dans les thermoéléments.
Application au chauffage domestique.

EP 0 017 083 A1

./...

FIG.4

## Dispositif thermoélectrique à transfert de chaleur entre deux fluides

La présente invention, due aux travaux de MM. Michel BERTHET, Jean-Claude KERMAREC et Robert RAVELET des Laboratoires de MARCOUSSIS, Centre de recherches de la Compagnie Générale d'Electricité, concerne un dispositif thermoélectrique à transfert de chaleur entre deux fluides comportant :

- d'une part au moins une pile d'éléments électriquement non isolants superposés en bon contact électrique et thermique selon une direction OZ, cette pile étant formée de plusieurs étages de pile comportant les éléments suivants :

- un thermoélément d'un premier type transférant la chaleur dans le sens du courant électrique,

- un conducteur thermique d'un premier type,

- un thermoélément du deuxième type transférant la chaleur dans le sens inverse du courant électrique,

- et un conducteur thermique d'un deuxième type,

- ce dispositif comportant d'autre part des connexions électriques aux deux extrémités de la pile pour faire passer un courant électrique à travers ces éléments en série,

- un premier et un deuxième circuits de fluides pour la circulation du premier et du deuxième fluides, respectivement,

- et des échangeurs thermiques d'un premier et d'un deuxième type pour assurer le transfert de chaleur entre la pile et les fluides circulant dans ce premier et ce deuxième circuit, respectivement ces échangeurs comportant les conducteurs thermiques du premier et du deuxième types, respectivement,

- et une colonne de maintien s'étendant à côté de la pile selon la même direction OZ,

- chaque étage de la pile comportant un élément de liaison s'étendant selon une direction OX sensiblement perpendiculaire à la direction OZ et rendant cet étage solidaire de la colonne de maintien.

Un tel dispositif comporte des thermoéléments (éléments thermoélectriques) montés entre des conducteurs thermiques associés à des échangeurs chauds parcourus par un fluide chaud et à des échangeurs froids parcourus par un fluide froid.

De tels dispositifs peuvent être utilisés pour engendrer un courant électrique continu lorsque les conducteurs thermiques sont maintenus à des températures différentes par le fluide chaud et le fluide froid, ou, au contraire, pour maintenir ces conducteurs thermiques à des températures différentes en vue de chauffer ou de refroidir un fluide par rapport à l'autre en faisant circuler un courant électrique continu dans les thermoéléments. Dans ce cas la chaleur est amenée aux thermoéléments et aux conducteurs thermiques par les échangeurs froids et transférée aux échangeurs chauds.

L'invention s'applique plus particulièrement, mais non exclusivement à ce dernier type de dispositifs, les thermoéléments étant alimentés en courant électrique continu pour entretenir une différence de température entre les conducteurs thermiques. Un tel dispositif, appelé "pompe à chaleur", peut aussi être utilisé à des fins de climatisation en réchauffant ou en refroidissant un fluide à partir de l'atmosphère ambiante.

Pour la construction de dispositifs thermoélectriques, on a déjà proposé de leur faire comporter des piles d'échangeurs chauds et froids électriquement conducteurs et séparés par des thermoéléments alternativement de types P et N, le courant électrique circulant dans le sens de l'empilement, ce sens étant vertical par exemple. Ces piles verticales sont disposées côte à côte de manière à constituer un ensemble d'allure parallélépipédique dans lequel les plaquettes constituant les thermoéléments sont disposés dans une succession de plans horizontaux et les échangeurs dans les plans horizontaux intermédiaires. Chaque échangeur est parcouru par l'un des fluides selon une direction horizontale qui n'est pas la même selon qu'il s'agit du fluide froid ou du fluide chaud.

La structure mécanique est prévue pour concilier les impératifs d'étanchéité concernant les circuits de fluide avec la présence de dilatations thermiques différentielles. La réalisation de cette structure est rendue particulièrement délicate par le fait que les thermoéléments connus à base de tellurure de bismuth sont extrêmement fragiles.

Une telle structure est par exemple décrite dans le brevet américain n° 3.626.704 (Coe).

Elle présente divers inconvénients dont l'un tient à la nécessité de maintenir la pile en compression permanente si l'on veut éviter des fractures des thermoéléments. Ceci peut évidemment être obtenu, comme connu, en disposant un élément élastique comprimé à une extrémité de la pile. Malheureusement, lors des petits déplacements qui affectent les étages de la pile en présence de dilatations thermiques différentielles, des frottements apparaissent nécessairement par rapport aux structures associées aux échangeurs thermiques. Ces frottements entraînent des mises en tension des thermoéléments et la fracture de ces derniers. De tels frottements sont d'autant moins évitables que la pile ne peut pas, en raison de la fragilité des thermoéléments, résister par elle-même à des efforts de flexion, et doit donc être maintenue latéralement sur toute sa hauteur.

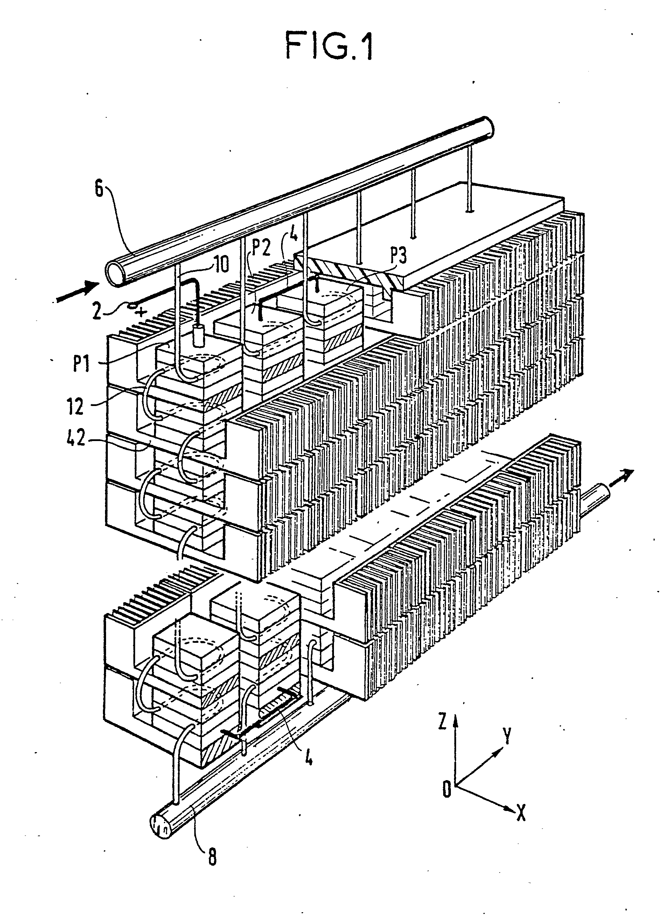

On connaît d'autre part, par la figure 1 de la demande allemande publiée (Offenlegungschrift) n° 2.201.338 un dispositif de transfert de chaleur utilisant une pile de thermoéléments 1 de types alternativement P et N séparés par des conducteurs thermiques 9 faisant partie d'échangeurs alternativement chauds et froids. Cette pile est maintenue à l'aide d'une structure rigide 3a, 3b disposée symétriquement de part et d'autre de la pile.

La symétrie de construction ne peut pas se conserver en service car l'un des éléments de cette structure est du côté froid, et l'autre du côté chaud, et le risque de fracture des thermoéléments est d'autant plus grand que les inconvénients des frottements apparaissant à chaque étage de la pile ne sont pas éliminés.

La présente invention a pour but la réalisation d'un dispositif thermoélectrique à transfert de chaleur entre deux fluides permettant d'éviter d'une manière simple toute mise en tension mécanique d'un thermoélément, tout en assurant une bonne rigidité mécanique au dispositif comportant cette pile et les échangeurs thermiques associés.

Elle a pour objet un dispositif thermoélectrique à transfert de chaleur entre deux fluides comportant :

- d'une part au moins une pile d'éléments électriquement non isolants superposés en bon contact électrique et thermique selon une direction OZ, cette pile étant formée de plusieurs étages de pile comportant les éléments suivants :

- un thermoélément d'un premier type transférant la chaleur dans le sens du courant électrique,

- un conducteur thermique d'un premier type,

- un thermoélément du deuxième type transférant la chaleur dans le sens inverse du courant électrique ,

- et un conducteur thermique d'un deuxième type,

- ce dispositif comportant d'autre part des connexions électriques aux deux extrémités de la pile pour faire passer un courant électrique à travers ces éléments en série,

- un premier et un deuxième circuits de fluides pour la circulation du premier et du deuxième fluides, respectivement,

- et des échangeurs thermiques d'un premier et d'un deuxième types pour assurer le transfert de chaleur entre la pile et les fluides circulant dans ce premier et ce deuxième circuit, respectivement, ces échangeurs comportant les conducteurs thermiques du premier et du deuxième types, respectivement,

-et une colonne de maintien s'étendant à côté de la pile selon la même direction OZ,

- chaque étage de la pile comportant un élément de liaison s'étendant selon une direction OX sensiblement perpendiculaire à la direction OZ et rendant cet étage solidaire de la colonne de maintien, caractérisé par le fait que

- chaque étage de la pile comporte un élément souple  comprimé élastiquement selon ladite  direction OZ.

    A l'aide des figures schématiques ci-jointes, on va décrire ci-après, à titre non limitatif, comment l'invention peut être mise en oeuvre. Lorsqu'un même élément est représenté sur plusieurs figures il y est désigné par le même signe de référence.

    La figure 1 représente une vue d'ensemble simplifiée des pièces principales d'un dispositif selon un premier mode de réalisation de l'invention, en perspective partiellement coupée. Ce dispositif constituant une pompe à chaleur eau-air et comportant une pile disposée selon une direction OZ verticale.

    La figure 2 représente une vue en perspective éclatée d'une partie du dispositif de la figure 1.

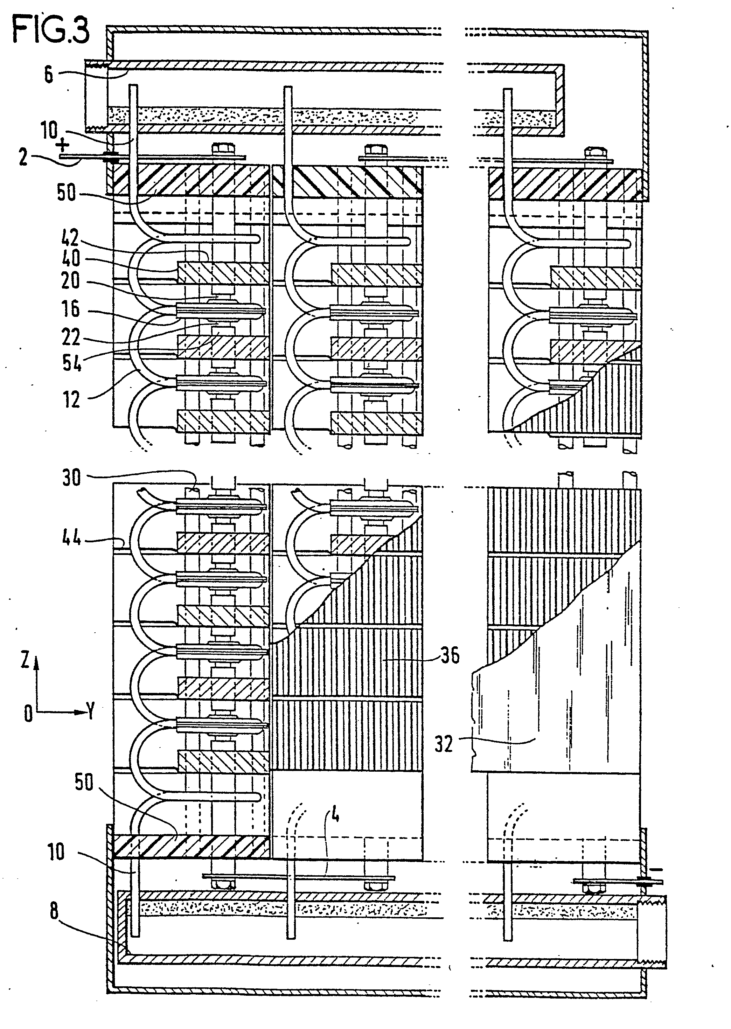

    La figure 3 représente une vue du même dispositif en coupe par un plan vertical parallèle à une direction horizontale OY.

    La figure 4 représente une vue du même dispositif en coupe par un plan vertical parallèle à une direction horizontale OX perpendiculaire à OY.

La figure 5 représente une vue de dessus d'un échangeur thermique à eau faisant partie du même dispositif.

La figure 6 représente une vue en coupe de l'échangeur de la figure 5, selon un plan VI-VI.

La figure 7 représente une vue en perspective éclatée des pièces principales d'un dispositif selon un deuxième mode de réalisation de l'invention, ce dispositif constituant une pompe à chaleur eau-eau et comportant une pile disposée selon ladite direction OZ.

Les figures 8 et 9 représentent des vues du dispositif de la figure 7 en coupe par deux plans verticaux respectivement parallèles auxdites directions OY et OX.

Le premier mode de mise en oeuvre de l'invention fonctionne thermiquement entre un premier fluide qui est l'air et un deuxième fluide qui est l'eau. L'air constitue la source chaude et est chauffé grâce au refroidissement de la source froide constituée par l'eau, c'est-à-dire que le dispositif constitue une pompe à chaleur eau-air. Cette pompe comporte une rangée de piles telles que P1, P2, P3 etc. constituées chacune par un empilement de thermoéléments et de conducteurs thermiques faisant partie d'échangeurs thermiques d'un premier type, à air et d'un deuxième type à eau. Chaque pile s'élève selon une direction verticale OZ, la rangée s'étendant selon une direction horizontale OY que l'on considèrera par exemple comme allant d'avant en arrière. Conformément à ce qui est représenté sur la figure 1, on peut considérer en première approximation que chaque pile représente la forme d'un prisme vertical à section carrée, deux côtés du carré étant parallèle à OY et deux autres à une direction horizontale OX perpendiculaire à OY que l'on considèrera par exemple comme allant de droite à gauche. Sur cette figure chaque pile présente quatre faces verticales : avant, droite, arrière et gauche. En fait, conformément à ce qui est représenté plus exactement sur les figures suivantes, les éléments qui composent la pile n'ont pas tous les mêmes dimensions horizontales, celles des thermoéléments étant notamment beaucoup plus petites que celles des échangeurs thermiques, l'axe de la pile étant une ligne verticale passant par les centres de tous les thermoéléments de la pile. Les échangeurs thermiques à air sont les plus larges. Ils comportent chacun une partie qui est située entre les thermoéléments. C'est cette partie intérieure à la pile qui constitue un conducteur thermique du premier type précédemment mentionné.

Chaque étage de la pile comporte un conducteur thermique du premier type faisant partie d'un échangeur thermique à air, un thermoélément d'un premier type P ou N, un conducteur thermique du deuxième type constituant un échangeur thermique à eau et un thermoélément d'un deuxième type opposé au premier.

Trois circuits sont connectés à ces piles à savoir un circuit électrique, et un premier et un deuxième circuits de fluides qui sont un circuit d'air et un circuit d'eau.

Le circuit électrique est destiné à faire traverser les thermoéléments par un courant électrique dirigé selon OZ, par exemple, pour les piles de rang pair telles que P2, et selon ZO pour les piles de rang impair telles que P1 et P3. Ces piles sont alimentées successivement en série à partir de deux bornes telles que 2 disposées chacune à une extrémité convenable de l'une des deux piles situées aux deux extrémités de la rangée. Une telle connexion en série permet d'obtenir une impédance acceptable de la pompe à chaleur malgré la faible impédance de chaque pile. Les connexions entre piles sont réalisées par des barrettes telles que 4 disposées alternativement en partie basse et en partie haute.

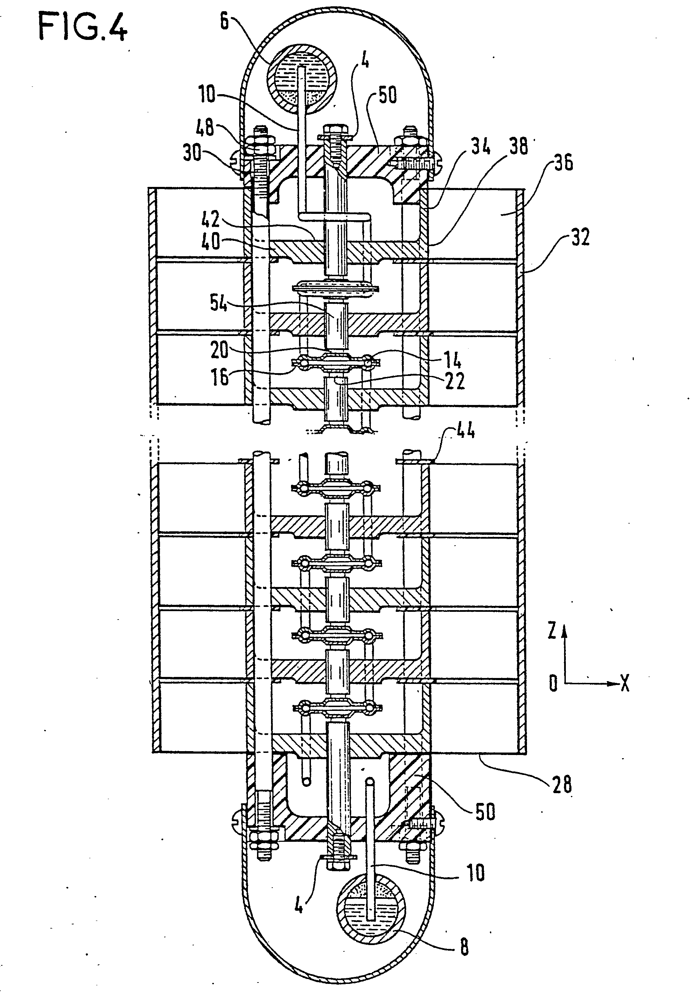

L'ensemble des circuits d'air de la rangée de piles est essentiellement constitué par deux conduits d'air verticaux tels que 28 (voir figure 4) formant deux nappes d'air symétriques à gauche et à droite de la rangée. Il serait évidemment possible mais le plus souvent moins avantageux, qu'il n'y ait qu'un seul conduit par pile, à gauche ou à droite, ou que les conduits correspondants aux diverses piles soient complètement séparés les uns des autres.

Chaque conduit tel que 28 est limité principalement par deux parois verticales parallèles au plan YOZ, une paroi interne 34 non homogène dont la composition sera décrite plus loin, et une paroi externe 32 par exemple isolante. Il peut être de plus limité à l'avant et l'arrière par deux plaques parallèles au plan XOZ et non représentées.

Tout le volume du conduit est occupé par un ensemble de blocs d'échange thermique tels que 36 constitués par des ailettes verticales présentant une grande surface d'échange thermique avec l'air, comme connu. Chacun de ces blocs fait partie d'un échangeur thermique comportant un conducteur thermique à air de la pile. Ces blocs se succèdent verticalement en regard d'une pile, et horizontalement d'avant en arrière, en regard des piles successives de la rangée. Ils sont constitués d'un métal bon conducteur thermique tel que l'aluminium. Ils sont fixés à la paroi interne 34 par soudure.

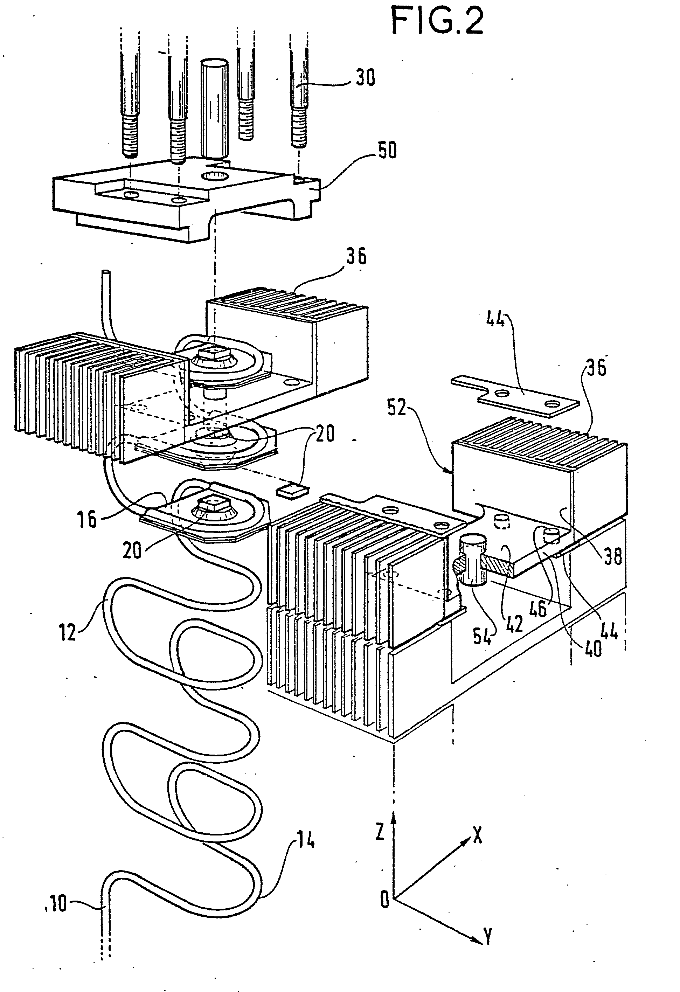

La paroi 34 est constituée par des joues latérales verticales, telles que 38 formant les extrémités relevées de bras horizontaux tels que 40 disposés à droite et à gauche, de chaque conducteur thermique à air tel que 54 (voir figures 2 et 4), en bon contact thermique. Plus particulièrement, ce dernier a la forme d'un cylindre plein vertical traversant le centre d'une plaque horizontale 42 et soudé à celle-ci et les deux côtés de cette plaque forment les deux bras 40 à droite et à gauche. Ces joues 38 présentent la forme de plaques rectangulaires disposées dans des plans parallèles à YOZ, et ayant des dimensions telles qu'elles occupent sensiblement toute la surface de la paroi 32. Pour éviter des courts-circuits électriques de minces feuilles isolantes telles que 44 sont disposées entre les bords des plaques adjacentes constituées par ces joues. Ces feuilles sont maintenues en position au montage grâce à des perforations qu'elles comportent et qui sont traversées par des tirants verticaux 30. Ces tirants traversent aussi les bras 40 par des ouvertures 46 de manière à les maintenir en place et à appuyer verticalement les joues 38 les unes sur les autres. Ils sont revêtus d'une gaine isolante pour éviter des courts-circuits électriques.

Il y a quatre tels tirants autour de chaque pile aux quatre coins de sa section carrée. Ils sont filetés à leurs extrémités de manière à permettre, à l'aide d'écrous 48 et de plaques d'appui isolantes 50, d'assurer au montage une compression efficace qui est essentiellement supportée par les joues 38, qui constituent ainsi des éléments de compression et forment un empilement. Ceci assure la rigidité de l'ensemble, et permet de maintenir les thermoéléments en compression.

L'ensemble de la plaque 42 avec les deux bras 40 à droite et à gauche, et des deux joues 38 aux extrémités de ces bras constitue une seule pièce 52 faite par exemple d'aluminium nickelé. Cette pièce peut être considérée comme formée de trois plaques qui sont deux plaques verticales parallèles au plan YOZ, c'est-à-dire les deux joues 38, et la plaque de base horizontale 42 réunissant les deux joues. Elle présente vue de l'avant, la forme d'un U, mais pourrait aussi présenter celle d'un I couché. Les joues 38 s'étendent vers l'arrière au-delà de la plaque de base 42 et ménagent entre elles un espace libre occupé partiellement par les tronçons de raccordement d'un conduit d'eau qui sera décrit plus loin. Une telle pièce a deux fonctions : une première fonction est qu'elle constitue un étage d'une colonne de maintien formée par l'empilement de pièces semblables, et coopérant avec les tirants 30 pour réaliser une structure mécanique rigide, solide et facile à monter, chaque étage de cette colonne correspondant à un étage de la pile. La deuxième fonction est de coopérer avec les blocs d'échange thermique 26 pour constituer un échangeur thermique à air à chaque étage de la pile.

Le contact entre les thermoéléments et la pièce 52 est assuré par les cylindres pleins 54 de même matière que cette dernière et disposés dans des orifices percés au centre des plaques 42 en faisant saillie au-dessus et au-dessous.

L'épaisseur de la plaque 42 est par exemple de 6 mm, sa largeur selon OY de 50 mm, sa longueur selon OX de 63 mm, les joues 38 ayant une épaisseur de 2 mm, une hauteur de 24 mm, et une largeur de 50 mm.

Le circuit d'eau comporte un collecteur d'entrée 6 amenant de l'eau tiède (15°C) et un collecteur de sortie 8, emmenant de l'eau refroidie (0°C), ces deux collecteurs étant disposés parallèlement à OY au-dessus et au-dessous de la rangée de piles. Les piles sont alimentées en parallèle entre ces deux collecteurs, chacune par un conduit tel que 10 qui traverse en série tous les conducteurs thermiques pour eau de la pile. L'extrémité inférieure de ce conduit est située sensiblement à la verticale de son extrémité supérieure, mais il présente entre les deux une forme sinueuse complexe constituée par une succession alternée de tronçons de raccordement tels que 12 et de tronçons d'échange thermique tels que 14 (voir figure 2). Chaque tronçon d'échange thermique est disposé dans un plan horizontal, dans un conducteur thermique à eau. Il est courbé de manière à entrer dans le conducteur thermique et à en sortir sur une même face de la pile de la figure 1, cette face étant parallèle au plan XOZ, par exemple la face avant. Il présente dans ce plan horizontal, la forme d'un U dont les branches sont parallèles à la direction OY, une branche étant à droite et l'autre à gauche. Sa section est sensiblement circulaire pour faciliter sa fabrication, et il serait souhaitable, si elle n'était pas circulaire, que sa plus grande dimension transversale soit inférieure au double de la plus petite. Si la plus grande dimension transversale est horizontale cette limitation a pour but d'éviter l'écrasement de ce conduit sous la force de compression verticale qui s'exerce sur la pile, comme il sera expliqué plus loin. Si cette plus grande dimension est verticale cette limitation a pour but d'éviter d'augmenter inutilement la hauteur de la pile.

Chaque tronçon de raccordement présente la forme d'un U dans un plan parallèle à YOZ, les branches du U étant parallèles à OY, l'une au-dessus l'autre au-dessous, en continuité avec les extrémités des tronçons d'échange thermique traversant deux conducteurs thermiques à eau se succèdant dans la pile. Tous les tronçons d'échange thermique se superposent. Les tronçons de raccordement se superposent alternativement dans deux plans parallèles à YOZ, l'un à droite, l'autre à gauche. Les tronçons d'échange thermique doivent présenter une résistance thermique faible à la traversée de leur paroi. Les tronçons de raccordement doivent présenter une résistance électrique longitudinale forte et pourraient dans certains cas être constitués d'un matériau isolant tel que le polychlorure de vinyle. Il a cependant été trouvé préférable d'éviter des collages, coûteux en main d'oeuvre si on veut qu'ils soient certainement étanches, et, pour cela, de constituer l'ensemble du conduit par un seul tube métallique uniforme d'épaisseur de paroi suffisamment faible (inférieure à 0,3 mm), en un métal relativement résistant électriquement et mécaniquement. Ce matériau est l'acier inoxydable. Dans l'exemple décrit l'épaisseur est de 0,1 mm, le diamètre extérieur étant de 2,5 mm. Il semble actuellement difficile de diminuer encore cette épaisseur.

Les tronçons d'échange thermique traversent les conducteurs thermiques à eau, tels que 16 précédemment appelés conducteurs thermiques du deuxième type, et coopérent avec eux pour constituer des échangeurs thermiques à eau, c'est-à-dire que ces conducteurs thermiques, qui font partie de la pile, transmettent directement la chaleur entre l'eau et les thermoéléments de la pile. Ils pourraient être constitués de diverses manières connues, par exemple, sous la forme de blocs massifs de cuivre traversés par les tronçons d'échange thermique du tube 10. Il a été cependant trouvé préférable de les constituer d'une manière peu coûteuse et, propre à leur conférer une certaine élasticité dans la direction de la pile. Une telle élasticité permet en effet de maintenir facilement la pile en compression sur toute la longueur malgré de petits déplacements longitudinaux qui lui sont imposés de place en place par une structure de maintien rigide qui lui est extérieure et qui subit des dilatations et contractions thermiques, cette structure étant ici constituée par la colonne de maintien précédemment mentionnée et formée par l'empilement des pièces 52 coopérant avec les tirants 30. Une telle compression permanente a pour avantage de diminuer le risque de fracture des thermoéléments, et, si une telle fracture se produit tout de même, de maintenir un contact électrique acceptable à l'endroit de la fracture.

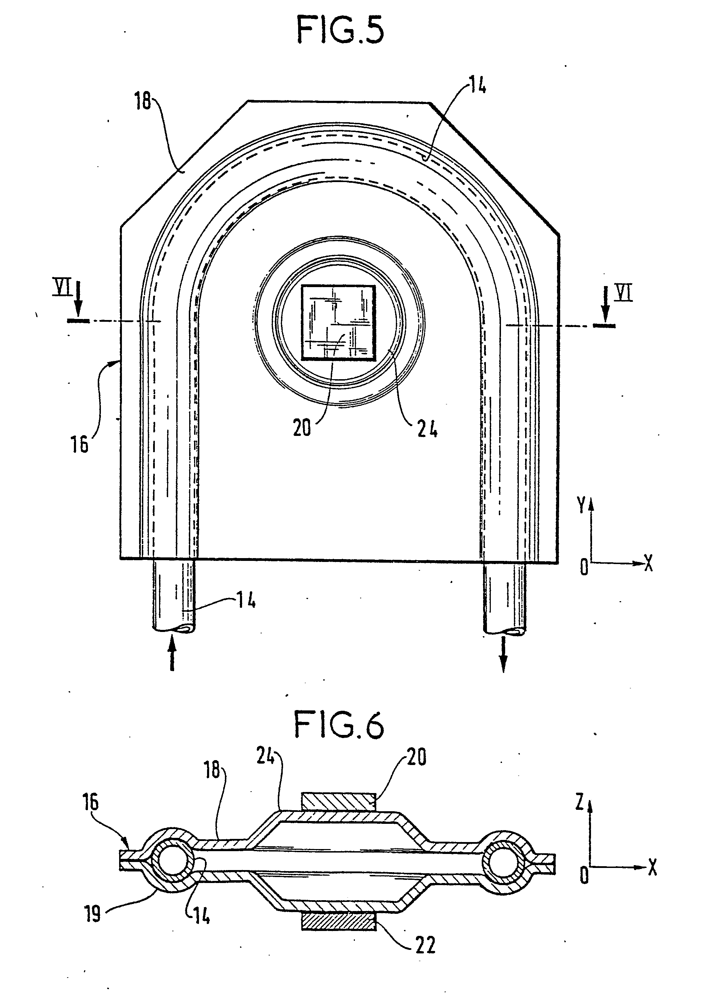

Chaque échangeur thermique à eau est constitué par deux tôles de cuivre (ou d'un autre métal bon conducteur thermique) soudées l'une à l'autre sur une partie de leurs bords et disposées symétriquement de part et d'autre du plan d'un tronçon d'échange thermique 14 auquel elles sont également soudées, de manière notamment à améliorer le contact thermique. On va par exemple décrire surtout la forme de la tôle supérieure 18, la tôle inférieure 19 lui étant identique (voir figures 5 et 6).

Il doit tout d'abord être compris que chaque tronçon d'échange thermique tel que 14 en forme de U fait un demi-tour autour de la zone comprimée de la pile dans laquelle se trouve les thermoéléments tels que 20 et 22, en forme de plaquettes carrées horizontales. Ces plaquettes sont disposées sensiblement à la verticale du centre d'un demi-cercle constituant la base du U. La tôle 18 recouvre le U et en déborde latéralement à droite et à gauche au-delà des branches et vers l'arrière au-delà de la base de manière que le U soit entièrement situé à l'intérieur de la tôle. La tôle 18 est emboutie de manière que sa partie qui déborde du U soit au contact de la tôle 19, dans le plan horizontal médian du tronçon d'échange thermique 14. C'est dans cette partie débordante que ces deux tôles sont soudées l'une à l'autre. Il n'y a ni rapprochement ni soudure des deux tôles sur le bord avant et dans toute la zone située entre les deux branches du U. La tôle 18 est emboutie de manière à s'écarter encore de la tôle 19 et à former une saillie centrale 24 vers le haut dans la zone sur laquelle est soudé le thermoélément 20. C'est l'espace compris entre les deux tôles sous la saillie centrale et jusqu'au tronçon d'échange thermique 14 qui, par flexion de la tôle, confère à l'échangeur thermique une certaine élasticité longitudinale, c'est-à-dire selon la direction OZ, car la liaison mécanique entre les thermoéléments 20 et 22 se fait par l'intermédiaire des tôles 18 et 19 qui ne sont solidarisées que par une partie de leurs bords et par le tronçon d'échange thermique 14.

A titre d'exemple, on peut donner les dimensions suivantes pour l'échangeur thermique à eau :
- distance entre les deux branches du U formée par le tronçon d'échange thermique 14 :                          23 mm,
- rayon de la saillie centrale 24 :                    4 mm,
- épaisseur des tôles 18 et 19    :                0,8 mm,
- distance moyenne maintenue entre les thermoéléments 20 et 22 (épaisseur de l'échangeur) : 6 mm.

Après montage de l'ensemble de la pile et de la colonne de maintien, à l'aide des tirants qui jouent le rôle de guide, on soude en une seule opération les cylindres 54 aux plaques 42, et les thermoéléments 20, 22 à ces cylindres et aux saillies centrales 24 des échangeurs à eau. On met ensuite la colonne de maintien en compression en serrant les écrous 48. L'espace intérieur compris entre les parois 34 est empli d'une mousse isolante polymérisée en place et destinée à éviter les courts-circuits thermiques.

Il doit être compris que tous les échangeurs thermiques à eau sont alors en état de compression longitudinale élastique, et ceci de manière permanente quelles que soient les températures de fonctionnement de la pile. Ceci résulte des conditions créées, lors de montage, et avant soudure : les cylindres pleins 54 peuvent alors coulisser légèrement par rapport aux plaques 42, de manière à compenser les différences de hauteurs des divers éléments par suite des tolérances de fabrication et assurer la répartition régulière des efforts longitudinaux. D'autre part une pression suffisante est exercée longitudinalement sur l'ensemble de la pile pour créer, dans les échangeurs thermiques à eau, une déformation élastique supérieure aux différences maximales de dilatation thermique qui peuvent apparaître ultérieurement entre la pile et la colonne de maintien. Cette force de pression est évidemment beaucoup plus faible que celle qui sera exercée ensuite, après soudure, par serrage des écrous 48, dans le but de rigidifier la colonne de maintien.

La pompe à chaleur eau-air ainsi réalisée peut être avantageusement utilisée pour le chauffage de l'air d'une pièce d'habitation à partir d'un circuit d'eau.

Elle peut être associée à divers dispositifs classiques de chauffage ou de climatisation.

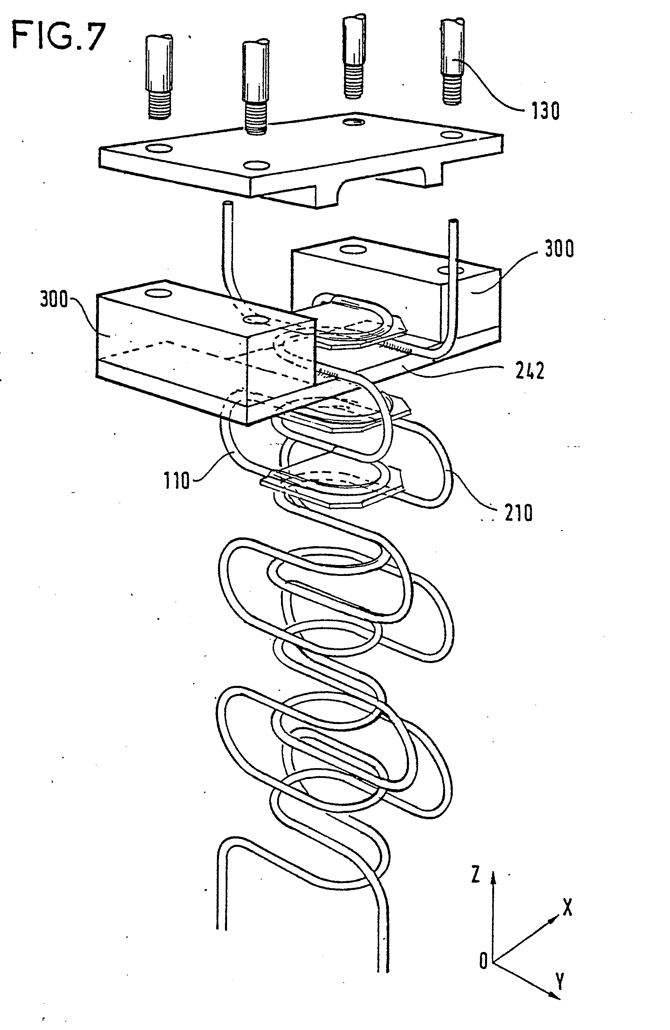

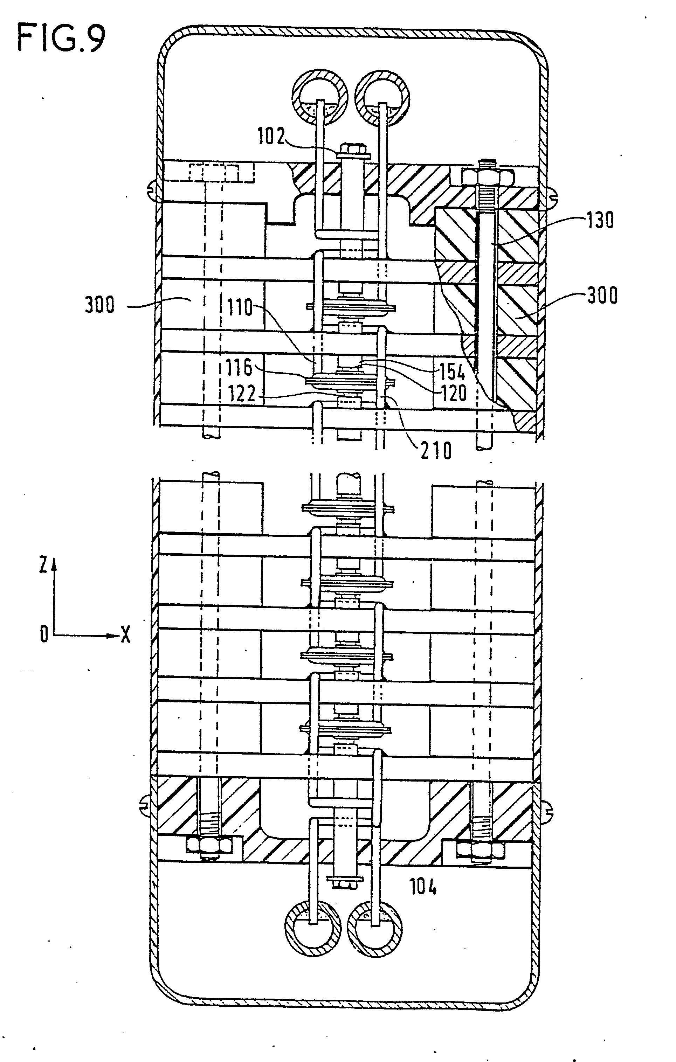

On peut également constituer selon un deuxième mode de réalisation de l'invention, une pompe à chaleur eau-eau représentée très schématiquement sur les figures 7, 8 et 9. Sauf indication ou évidence contraires les précisions données à propos des éléments premier mode de réalisation et de leur disposition sont valables pour les éléments correspondants du deuxième, qui porte des nombres de référence augmentés de 100.

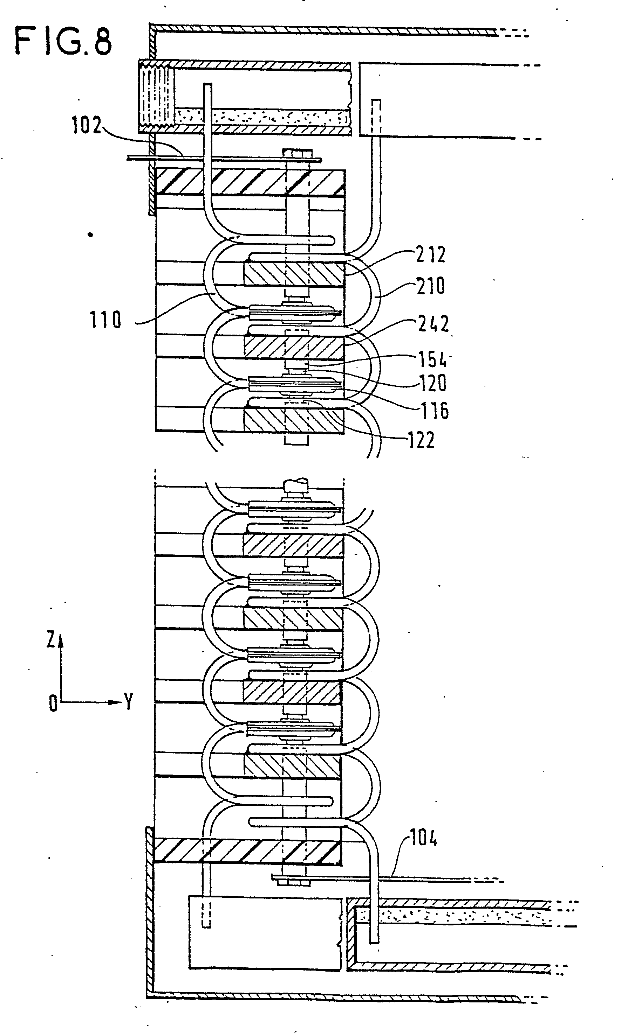

Cette pompe est constituée essentiellement par une pile verticale (direction OZ) alimentée électriquement par l'intermédiaire de bornes telles que 102 et 104 (figure 8). Chaque étage de cette pile comporte un conducteur thermique d'un premier type tel que 154 par exemple chaud, un thermoélément de type P tel que 120, un conducteur thermique d'un deuxième type tel que 116, par exemple froid, et un thermoélément de type N tel que 122. Chaque conducteur thermique fait partie d'un échangeur de chaleur qui dans le cas de l'échangeur froid est constitué par un conducteur thermique 116 coopérant avec le tube 110 du circuit froid et est identique à l'échangeur 16 coopérant avec le tube 10 du premier mode de réalisation. Quant à l'échangeur chaud il comporte, outre le conducteur 154 identique au conducteur 54 du premier mode de réalisation, une plaque 242, plane et rectangulaire, coopérant avec le conducteur 154 de la même façon que la plaque 42 avec le conducteur 54 dans le premier mode de réalisation. Cette plaque est complètement plane. Elle a deux fonctions : d'abord elle transporte la chaleur entre le conducteur thermique 154 et un tube 210 faisant partie d'un circuit d'eau chaude  (premier circuit de fluide). Ce tube est identique au tube 110 sauf qu'il est retourné par symétrie par rapport à un plan XOZ, et décalé en hauteur. Ce tube 210 est soudé, par ses tronçons d'échange thermique sur la plaque 242 de manière à assurer un bon contact thermique.

La plaque 242 constitue d'autre part un élément de liaison avec une colonne de maintien constitué par l'empilement de telles plaques et de blocs de matière plastique 300 servant d'élément de compression et disposés à droite et à gauche des échangeurs 116. L'empilement de ces plaques et de ces blocs est maintenu en compression par quatre tirants verticaux tels que 130 qui traversent ces plaques et ces blocs. Ces tirants sont identiques aux tirants 30 du premier mode de réalisation. Les connexions des deux circuits d'eau sont analogues à celles du circuit d'eau du premier mode de réalisation.

Il est bien clair que d'autres modes de réalisation de l'invention sont encore possibles dans des cas particuliers. Quoique cela ne semble pas avantageux, dans les conditions techniques actuelles , il serait par exemple possible, si les considérations d'encombrement et de difficulté de montage ne sont pas très importantes, et si le débit d'eau est grand, de modifier le premier mode de réalisation (pompe à chaleur eau-air) en changeant la forme du circuit d'eau. Pour chaque pile telle que P1, ce circuit serait constitué par deux conduits connectés en parallèle et disposés dans deux plans parallèles à YOZ, l'un à droite des thermoéléments, l'autre à gauche. Les deux tronçons d'échange thermique de chaque étage seraient alors constitués de tubes métalliques rectilignes disposés selon la direction OY, et les tronçons de raccordement seraient formés par des tubes métalliques ou plastiques coudés en forme de U et disposés alternativement en avant et en arrière de la pile.

Plus généralement encore l'utilisation selon l'invention d'un élément élastique à chaque étage de la pile, avec liaison, également à chaque étage, à une colonne de maintien rigide, est compatible avec toute forme de circuits de fluides caloporteurs, pourvu que ces circuits soient suffisamment souples pour ne pas transmettre de contraintes mécaniques gênantes à la pile lors des dilatations thermiques différentielles. Il en est de même pour l'utilisation préférée, selon l'invention, d'une colonne de maintien réalisée sous forme symétrique, ce qui, en présence de variations de température, élimine le risque de courbure de cette colonne.

REVENDICATIONS

1/ Dispositif thermoélectrique à transfert de chaleur entre deux fluides comportant :

- d'une part au moins une pile (P1) d'éléments électriquement non isolants superposés en bon contact électrique et thermique selon une direction OZ, cette pile étant formée de plusieurs étages de pile comportant les éléments suivants :

- un thermoélément (20) d'un premier type transférant la chaleur dans le sens du courant électrique,

- un conducteur thermique (54) d'un premier type,

- un thermoélément (22) du deuxième type transférant la chaleur dans le sens inverse du courant électrique,

- et un conducteur thermique (16) d'un deuxième type,

- ce dispositif comportant d'autre part des connexions électriques (24) aux deux extrémités de la pile pour faire passer un courant électrique à travers ces éléments en série,

- un premier (28) et un deuxième (10) circuits de fluides pour la circulation du premier et du deuxième fluides, respectivement,

- et des échangeurs thermiques d'un premier (54, 42, 40, 38, 26) et d'un deuxième (14, 16) types pour assurer le transfert de chaleur entre la pile (P1) et les fluides circulant dans ce premier et ce deuxième circuit, respectivement, ces échangeurs comportant les conducteurs thermiques du premier et du deuxième types, respectivement,

- et une colonne de maintien (52) s'étendant à côté de la pile selon la même direction OZ,

- chaque étage de la pile comportant un élément de liaison (40) s'étendant selon une direction OX sensiblement perpendiculaire à la direction OZ et rendant cet étage solidaire de la colonne de maintien,

- caractérisé par le fait que chaque étage de la pile comporte un élément souple (16) comprimé élastiquement selon ladite direction OZ.

2/ Dispositif selon la revendication 1, caractérisé par le fait que l'élément souple de chaque étage est constitué par le conducteur thermique (16) du deuxième type.

3/ Dispositif selon la revendication 2, caractérisé par le fait que le conducteur thermique (16) du deuxième type est essentiellement constitué par deux tôles souples (18,19) superposées, constituées d'un métal bon conducteur thermique, et s'étendant sensiblement selon des plans perpendiculaires à la direction OZ, en laissant entre elles un intervalle libre entre des thermoéléments (20,22), ces tôles étant solidarisées l'une à l'autre à distance de cet intervalle libre.

4/ Dispositif selon la revendication 3, caractérisé par le fait qu'à distance de l'intervalle libre les deux tôles sont fixées en bon contact thermique à un tube (14) faisant partie du deuxième circuit (10) de fluide de manière à constituer un échangeur thermique entre la pile (P1) et ce circuit.

5/ Dispositif selon la revendication 1, caractérisé par le fait que la colonne de maintien est constituée essentiellement par un empilement d'étages de compression rigides et par des tirants (30) munis de moyens (48, 50) pour s'appuyer sur les deux extrémités de cet empilement,

- chaque étage de compression comportant une plaque (40) de faible extension selon direction OZ, constituant ledit élément de liaison et s'étendant de part et d'autre de la pile selon les deux directions opposées OX et XO,

- cette plaque se raccordant à ses deux extrémités à deux éléments de compression (38) ayant une plus grande extension selon la direction OZ de manière à venir en appui respectivement contre les deux éléments de compression de l'étage suivant et/ou précédant et à former ainsi de chacun des deux côtés opposés de la pile une colonne de compression constituée par l'empilement de ces éléments de compression,

- lesdits tirants (30) passant entre ces deux colonnes de compression et étant munis à chacune de leurs deux extrémités de moyens pour s'appuyer sur les deux extrémités de chacune de ces deux colonnes de maintien, de manière à constituer ainsi une structure rigide qui est entièrement comprise entre les faces extérieures de ces colonnes de compression et qui est réalisable par un simple empilage d'étages (40, 38) suivi de la mise en place de ces tirants,

- ladite pile comportant lesdits éléments souples (16) étant disposée à l'intérieur de cette structure rigide.

0017083

# FIG.1

0017083

# FIG.2

FIG.3

0017083

FIG.4

# FIG.5

# FIG.6

FIG.7

130

300

300

242

110

210

Z

X

0

Y

0017083

FIG.8

0017083

FIG.9

**Office européen des brevets**

# RAPPORT DE RECHERCHE EUROPEENNE

Numéro de la demande

EP 80 10 1435

## DOCUMENTS CONSIDERES COMME PERTINENTS

| Catégorie | Citation du document avec indication, en cas de besoin, des parties pertinentes | Revendication concernee |
|---|---|---|
| | FR - A - 2 035 167 (SIEMENS)<br>* Figures 6,20; revendications 1-3, 11 *<br><br>-- | 1-3,5 |
| D | DE - A - 2 201 338 (ALLMANNA)<br>* Figures 1,2; revendications 1-3, 5,10,11 *<br><br>----- | 1,5 |

**CLASSEMENT DE LA DEMANDE (Int. Cl. 3)**

H 01 L 35/30
       35/32
       25/08
F 25 B 21/02
       29/00

**DOMAINES TECHNIQUES RECHERCHES (Int. Cl. 3)**

H 01 L 35/30
       35/32
       25/08
F 25 B 21/02
       29/00
F 24 J   3/04

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 03.07.1980 | DE RAEVE |

OEB Form 1503.1 06.78